(19) **Europäisches Patentamt**

**European Patent Office**

**Office européen des brevets**

(11) **EP 1 403 939 B1**

(12) **EUROPEAN PATENT SPECIFICATION**

(45) Date of publication and mention
of the grant of the patent:
**01.03.2006 Bulletin 2006/09**

(51) Int Cl.:
*H01L 27/32* (2006.01)     *H05B 33/22* (2006.01)

(21) Application number: **03021955.4**

(22) Date of filing: **29.09.2003**

(54) **Light-emitting device, display and lighting unit**

Lichtemittierende Vorrichtung, Anzeige und Beleuchtungseinheit

Dispositifs d'émission de lumière, d'affichage et d'éclairage

(84) Designated Contracting States:
**DE FI GB NL**

(30) Priority: **30.09.2002 JP 2002287026**
              **30.09.2002 JP 2002287025**

(43) Date of publication of application:
**31.03.2004 Bulletin 2004/14**

(73) Proprietor: **KABUSHIKI KAISHA TOYOTA
JIDOSHOKKI
Kariya-shi,
Aichi-ken (JP)**

(72) Inventor: **Kato, Yoshifumi
Kariya-shi
Aichi-ken (JP)**

(74) Representative: **TBK-Patent
Bavariaring 4-6
80336 München (DE)**

(56) References cited:
**US-A- 5 682 402**         **US-A- 5 804 919**

• NAKAYAMA T ET AL: "INVESTIGATIONS ON MULTICOLOR DISPLAY BY ORGANIC LUMINESCENT DEVICESWITH OPTICAL MICROACTIVITY STRUCTURE"ELECTRONICS & COMMUNICATIONS IN JAPAN, PART II - ELECTRONICS, SCRIPTA TECHNICA. NEW YORK, US, vol. 78, no. 2, 1 February 1995 (1995-02-01), pages 98-104, XP000526351 ISSN: 8756-663X
• DODABALAPUR A ET AL: "COLOR VARIATION WITH ELECTROLUMINESCENT ORGANIC SEMICONDUCTORS IN MULTIMODE RESONANT CAVITIES" APPLIED PHYSICS LETTERS, AMERICAN INSTITUTE OF PHYSICS. NEW YORK, US, vol. 65, no. 18, 31 October 1994 (1994-10-31), pages 2308-2310, XP000476525 ISSN: 0003-6951
• BURROWS P E ET AL: "CONTROL OF MICROCAVITY EFFECTS IN FULL COLOR STACKED ORGANIC LIGHT EMITTING DEVICES" APPLIED PHYSICS LETTERS, AMERICAN INSTITUTE OF PHYSICS. NEW YORK, US, vol. 73, no. 4, 27 July 1998 (1998-07-27), pages 435-437, XP000774905 ISSN: 0003-6951
• FUKUDA Y ET AL: "AN ORGANIC LED DISPLAY EXHIBITING PURE RGB COLORS" SYNTHETIC METALS, ELSEVIER SEQUOIA, LAUSANNE, CH, vol. 111/112, 1 June 2000 (2000-06-01), pages 1-6, XP000965771 ISSN: 0379-6779

## Description

The present invention relates to a light-emitting device, a display unit and a lighting unit.

A reflective liquid crystal display unit, a transmissive liquid crystal display unit and a semi-transmissive liquid crystal display unit have been previously proposed (e.g. Japanese Unexamined Patent Publication No. 10-78582). In the transmissive liquid crystal display unit and the semi-transmissive liquid crystal display unit, an organic electroluminescent, hereinafter "EL", device has been utilized as a backlight (a light source). The modification of the backlight also has been previously proposed [e.g. Jiro Yamada, Takashi Hirano, Yuichi Iwase, and Tatsuya Sasaoka, "Micro Cavity Structures for Full Color AM-OLED Displays", The Ninth International Workshop on Active-Matrix Liquid-Crystal Displays-TFT Technologies and Related Materials- (AM-LCD '02) Digest of Technical Papers, sponsored by the Japan Society of Applied Physics, July 10, 2002 p. 77-80].

Nakayama et al: 'Investigations on multicolor display by organic luminescent devices with optical microcavity structure' Electronics & Communications in Japan, part II - Electronics, Scripta Technica. New York, US, vol. 78, no. 2, 1 February 1995 (1995-02-01), pages 98-104, XP000526351 ISSN: 8756-663X discloses that the EL device includes a microcavity by which light is resonated. According to the structure of the EL device, the spectrum of the emitted light has two peaks. Since a half mirror (reflector) is formed by multidielectric layer, ($TiO_2/SiO_2$ multilayer), light is reflected at each layer of the multidielectric layer, the reflected lights interfere with each other, and also the optical length of the resonant cavity is longer, thus resonating light with another wavelength.

US-A-5 682 402 describes a plurality of resonators (first and second resonators) being formed on a transparent substrate, wherein light output of a desired wavelength is obtained using resonance characteristics of the two resonators. Herein, a light-emitting device is shown which includes two resonators A and B, and a reflective electrode 1 of the device is a reflector of the two resonators. Light having emission spectra is obtained by the resonators A and B, respectively, and the emission spectrum is obtained by combining the above spectra. Namely, the device includes the two resonators, by which light having the desired wavelength is obtained.

US-A-5 804 919 shows a resonant microcavity display having microcavity with a substrate, a phosphor active region and front and rear reflectors. Herein, a resonant microcavity display is shown having three microcavities arranged adjacent to each other.

Dodabalapur A et al: 'Color variation with electroluminescent organic semiconductors in multimode resonant cavities' Applied Physics Letters, American Institute of Physics. New York, US, vol. 65, no. 18, 31 October 1994 (1994-10-31), pages 2308-2310, XP000476525 ISSN: 0003-6951 relates to color variation with electroluminescent organic semiconductors in multimode resonant cavities.

## SUMMARY OF THE INVENTION

It is the object of the present invention to provide an improved light-emitting device, an improved display unit and an improved lighting unit.

In order to solve this object, the present invention provides a light-emitting device, a display unit and a lighting unit that amplify the lights with a plurality of predetermined colors emitted from a light source body by optical resonance and can take out the amplified lights.

Thus, in one aspect of the present invention, there is provided a light-emitting device according to claim 1.

In another aspect of the present invention, there is provided a display unit according to claim 11.

In still another aspect of the present invention, there is provided a lighting unit according to claim 14.

Further advantageous developments are set out in the dependent claims:

## BRIEF DESCRIPTION OF THE DRAWINGS

The present invention together with objects and advantages thereof may best be understood by reference to the following description of the presently preferred embodiments together with the accompanying drawings in which:

FIG. 1 is a cross-sectional view of a liquid crystal display unit according to a first preferred embodiment of the present invention;

FIG. 2 is a partially enlarged cross-sectional view of a backlight according to the first preferred embodiment of the present invention;

FIG. 3 shows the spectrums of light emitted from an organic EL layer and light going out from the backlight according to the first preferred embodiment of the present invention;

FIG. 4 is a partially enlarged cross-sectional view of a backlight according to a first alternative preferred embodiment of the present invention;

FIG. 5 is a partially enlarged cross-sectional view of a backlight according to a third alternative preferred embodiment of the present invention;

FIG. 6 is a partially enlarged cross-sectional view of a backlight;

FIG. 7 is a partially enlarged cross-sectional view of a backlight;

FIG. 8 is a partially enlarged cross-sectional view of a liquid crystal display unit according to an alternative preferred embodiment of the present invention;

FIG. 9 is a cross-sectional view of a liquid crystal display unit of a alternative preferred embodiment;

FIG. 10A is a cross-sectional view of an optical resonator; and

FIG. 10B is a cross-sectional view of optical resonators.

DETAILED DESCRIPTION OF THE PREFERRED EMBODIMENTS

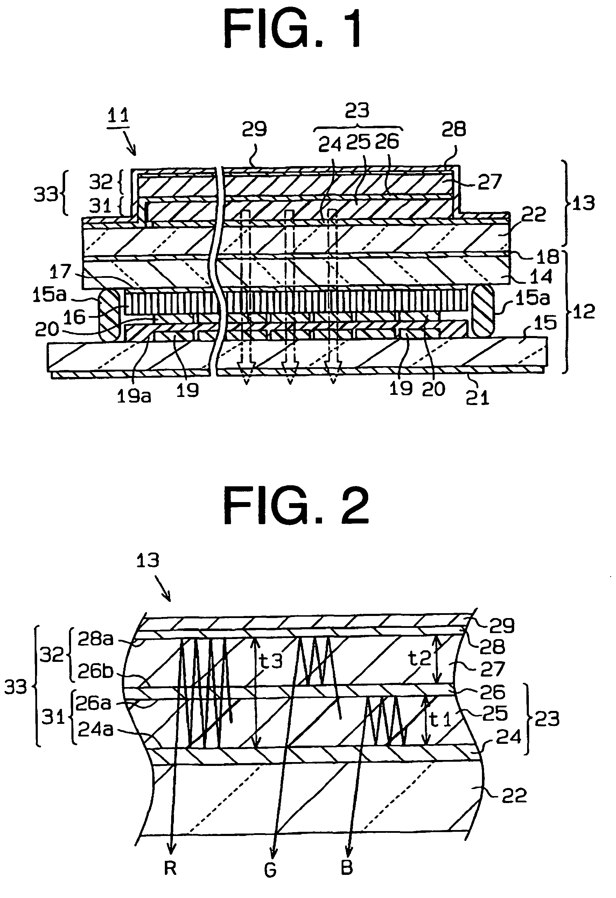

Now, a preferred embodiment of the present invention will be described by referring to FIGS. 1 through 4. The present invention is applied to a liquid crystal display unit that employs a passive matrix mode. FIG. 1 is a cross-sectional view of a liquid crystal display unit. FIG. 2 is a partially enlarged cross-sectional view of a backlight. In FIGS. 1 and 2, the ratio of the thickness of each member is not accurate in order to illustrate clearly.

As shown in FIG. 1, a liquid crystal display unit 11 or a display unit has a liquid crystal panel 12 or a transmissive liquid crystal display that employs a passive matrix mode, and a backlight 13.

The liquid crystal panel 12 includes a pair of transparent substrates 14 and 15. The substrates 14 and 15 are separated from each other by sealant 15a so as to keep a predetermined interval between the substrates 14 and 15. A liquid crystal 16 is arranged between the substrates 14 and 15. For example, the substrates 14 and 15 are made of glass. The substrate 14 is arranged adjacent to the backlight 13. A plurality of transparent electrodes 17 is formed on the surface of the substrate 14 corresponding to the liquid crystal 16 so as to form parallel stripes in shape. A polarizing plate 18 is formed on the surface of the substrate 14 at the side opposite to the liquid crystal 16.

The liquid crystal panel 12 also includes color filters 19 and a planarizing film 19a for planarizing the unevenness caused by the color filters 19. The color filters 19 and the planarizing film 19a are formed on the surface of the substrate 15 corresponding to the liquid crystal 16. Transparent electrodes 20 are formed on the planarizing film 19a so as to extend in a direction perpendicular to the electrodes 17. A polarizing plate 21 is formed on the surface of the substrate 15 opposite to the surface of the substrate 15 on which the electrodes 20 are formed. The electrodes 17 and 20 are made of ITO (Indium Tin Oxide). Each of the intersections of the electrodes 17 and 20 forms a sub pixel of the liquid crystal panel 11. The sub pixels are arranged so as to form a matrix. Three of the sub pixels that respectively correspond to R (red), G (green) and B (blue) constitute a pixel. The sub pixels can be driven in each line for display by scanning of the electrodes 17.

As shown in FIGs. 1 and 2, the backlight 13 is a light-emitting device. The backlight 13 includes a substrate 22 and an organic EL device 23 that has an organic EL layer containing organic EL material. The organic EL device 23, or a light source body that generates light, is formed on the substrate 22. The backlight 13 is arranged such that the substrate 22 is located adjacent to the liquid crystal panel 12. That is, the backlight 13 is arranged at the back side of the liquid crystal panel 12. The backlight 13 is a bottom emission type backlight in which the light exits from the side of the substrate 22. The substrate 22 is made of glass.

A first electrode 24, an organic EL layer 25 containing organic EL material, and a second electrode 26 are layered on the substrate 22 in order of mention so as to constitute the organic EL device 23. The first electrode 24, the organic EL layer 25 and the second electrode 26 are planar. The first electrode 24, the organic EL layer 25 and the second electrode 26 are defined as same shape and same size of the liquid crystal panel 12, so that the light at whole area of the backlight 13 can be hit at whole area of the liquid crystal panel 12.

A buffer layer 27 is layered on the second electrode 26, and a reflecting mirror 28 as a reflector is layered on the buffer layer 27. The buffer layer 27 and the reflecting mirror 28 are planar. The buffer layer 27 and the reflecting mirror 28 are defined as same shape and same size of the liquid crystal panel 12.

The organic EL device 23 is covered with a passivation film 29 in order not to contact air. In the present preferred embodiment, the passivation film 29 is formed so as to cover the first electrode 24, all end faces of the organic EL layer 25, the second electrode 26 and the buffer layer 27, and the surface of the reflecting mirror 28. The passivation film 29 is made of material through which water does not permeate, for example, silicon nitride ($SiN_x$) and silicon oxide (SiOx).

The organic EL layer 25, for example, has a known structure that has at least three layers including a hole injection layer, a luminous layer and an electron injection layer. The hole injection layer, the luminous layer and the electron injection layer are layered in order of mention from the side of the first electrode 24. The organic EL layer 25 is constituted of a white luminous layer.

The first and second electrodes 24 and 26 are formed so as to function as half mirrors that partially reflect light. Each of the first and second electrodes 24 and 26 is formed at the thickness of 30nm or less, so as to have light penetrability. In the preferred embodiment, the first electrode 24 serves as an anode, and the second electrode 26 serves as a cathode. The first and second electrodes 24 and 26 are made of metal. In the preferred embodiment, the first electrode 24 is made of chromium, and the second electrode 26 is made of aluminum. The buffer layer 27 is made of transparent material. In the preferred embodiment, the buffer layer 27 is made of oxide film, more particularly silicon oxide. The reflecting mirror 28 does not have penetrability and totally reflects the light. Also, the reflecting mirror 28 is made of metal, aluminum in the preferred embodiment.

As shown in FIG. 2, in the backlight 13, the organic EL layer 25 is sandwiched between a surface 24a of the first electrode 24 and a surface 26a of the second electrode 26 that face each other. The surfaces 24a and 26a as reflecting surfaces and the organic EL layer 25 constitute a first resonant layer 31. The buffer layer 27 is sandwiched between a surface 26b of the second electrode 26 and a surface 28a of the reflecting mirror 28 that face each other. The surfaces 26b and 28a as reflecting surfaces and the buffer layer 27 constitute a second resonant layer 32. The surfaces 24a and 28a as reflecting surfaces, the organic EL layer 25, the second electrode 26 and the buffer layer 27 constitute a third reflecting layer 33. The organic EL layer 25, the second electrode 26 and the buffer layer 27 are sandwiched between the surfaces 24a and 28a of the third reflecting layer 33. As mentioned above, in each of the resonant layers 31 through 33, the surfaces of two reflectors are faced at a particular distance from each other. Also, since the first and second electrodes 24 and 26 are translucent reflectors, at least one of the reflectors is a translucent reflector in each of the resonant layers 31 through 33. The first, second and third resonant layers 31 through 33 are formed adjacent to each other in a overlapping direction which the first, second and third resonant layers 31 through 33 overlap. The first electrode 24 serves as a reflector for the first and the third resonant layers 31 and 33. The second electrode 26 serves as a reflector for the first and second resonant layers 31 and 32. The reflecting mirror serves as a reflector for the second and third resonant layers 32 and 33.

As mentioned above, the backlight includes the first electrode 24 or a first reflector, the second electrode 26 or a second reflector, and the reflecting mirror 28 or a third reflector in order from a light output side or a first side through which the light is output. The first electrode 24 is arranged at the light output side. The second electrode 26 is arranged adjacent to the first electrode 24 at a second side opposite to the light output side. The reflecting mirror 28 is arranged adjacent to the second electrode 26 at the second side. Namely, the first and second electrodes 24 and 26 and the reflecting mirror 28 are arranged in the overlapping direction, that is, in a direction in which the first and second electrodes 24 and 26 and the reflecting mirror 28 overlap. Both surfaces 26a and 26b of the second electrode 26 are reflecting surfaces. The surface 26a faces the surface 24a that is a reflecting surface of the first electrode 24. The surface 26b faces the surface 28a that is a reflecting surface of the reflecting mirror 28.

In the present preferred embodiment, a wavelength $\lambda 1$ denotes the wavelength of a first light resonated by the first resonant layer 31. A wavelength $\lambda 2$ denotes the wavelength of a second light resonated by the second resonant layer 32. A wavelength $\lambda 3$ denotes the wave-length of a third light resonated by the third resonant layer 33. Also, a thickness t1 denotes the thickness of the first resonant layer 31, a thickness t2 denotes the thickness of the second resonant layer 32, and a thickness t3 denotes the thickness of the third resonant layer 33. The thickness t1 corresponds to the distance between the surface 24a of the first electrode 24 and the surface 26a of the second electrode 26, which are reflecting surfaces and which face each other. The thickness t2 corresponds to the distance between the surface 26b of the second electrode 26 and the surface 28a of the reflecting mirror 28, which are reflecting surfaces and which face each other. The thickness t3 corresponds to the distance between the surface 24a of the first electrode 24 and the surface 28a of the reflecting mirror 28, which are reflecting surfaces and which face each other. Also, the thickness t1 corresponds to the distance between the first and second electrodes 24 and 26, which resonate the first light with the wavelength $\lambda 1$. The thickness t2 corresponds to the distance between the second electrode 26 and the reflecting mirror 28, which resonate the second light with the wavelength $\lambda 2$. The thickness t3 corresponds to the distance between the first electrode 24 and the reflecting mirror 28, which resonate the third light with the wavelength $\lambda 3$.

Namely, the sum of the thickness t1 of the first resonant layer 31 and the thickness t2 of the second resonant layer 32 is substantially equal to the thickness t3 of the third resonant layer 33.

In the preferred embodiment, the first resonant layer 31 resonates B light, the second resonant layer 32 resonates G light, and the third resonant layer 33 resonates R light. The wavelength $\lambda 1$ is the wavelength of the B light, the wavelength $\lambda 2$ is the wavelength of the G light, and the wavelength $\lambda 3$ is the wavelength of the R light.

As mentioned above, the wavelengths $\lambda 1$, $\lambda 2$ and $\lambda 3$ of the lights that are amplified by resonance are respectively determined to be equal to target wavelengths corresponding to B, G and R.

Wave ranges of B, G and R lights that are amplified are respectively selected from the following desired ranges:

$$\lambda 1 \ (B) = 430nm \sim 500nm;$$

$$\lambda 2 \ (G) = 520nm \sim 560nm;$$

and

$$\lambda 3 \ (R) = 570nm \sim 650nm.$$

Since the wave ranges of the R and B lights being located in the ends of a visible light range are generally broader than those of the other colors, the wave ranges of R and B are broader than that of G light. The wave range of G light is located in the middle of the visible light range. When a wavelength slightly changes around the G light range, the color of the light changes to yellow or light blue. Therefore, the width of the G light range is 40nm, which is narrow. Since the relationship between color and wavelength in natural light is slightly different from the relationship between color and wavelength in the liquid crystal display unit and TV, the R light range is determined so as to include a short wavelength compared to the R light range of the natural light.

The above-constructed backlight 13 is manufactured by vapor deposition of the first electrode 24, the organic EL layer 25, the second electrode 26, the buffer layer 27, the reflecting mirror 28 and the passivation film 29 on the substrate 22 in order of mention.

Next, the action of the above-constructed liquid crystal display unit 11 will be described. A drive control device that is not shown in figures applies a voltage to the liquid crystal panel 12 between the electrodes 17 and 20, so that the desired pixel is capable of being penetrated.

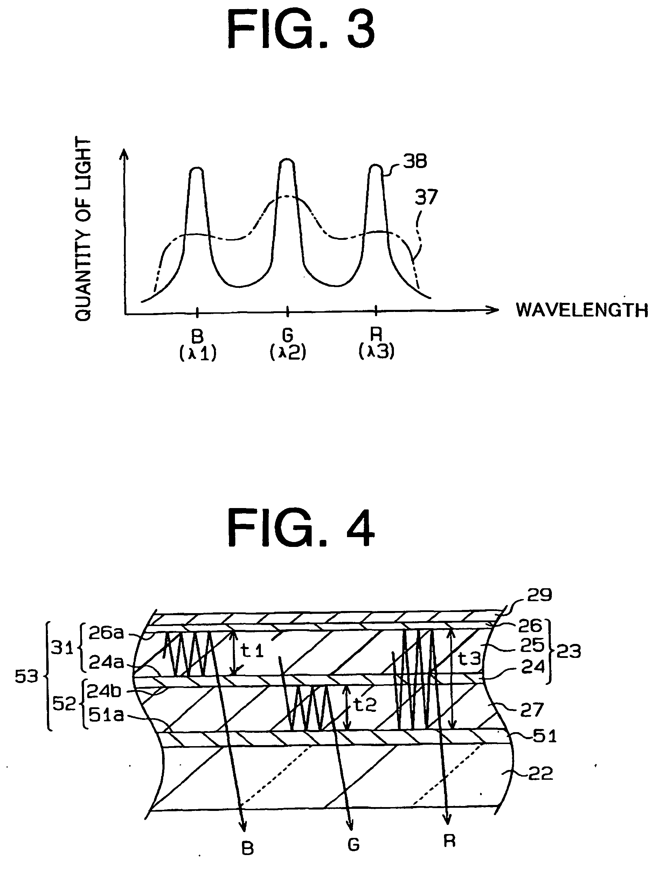

Meanwhile, when the backlight 13 is switched on, the drive control device applies a voltage to the backlight 13 between the first and second electrodes 24 and 26, and the organic EL device 23 emits white light including a plurality of colors. In FIG. 3, a first line 37 indicated by a two-dot chain line denotes the spectrum of the white light emitted from the organic EL layer 25.

There is light emitted from the organic EL layer 25 that is reflected by the surfaces 24a and 26a in the first resonant layer 31. The thickness t1 is equal to the value that the half of the wavelength of the above light is multiplied by a natural number. In this case, the B light is resonated by the first resonant layer 31 and amplified. The B light is amplified by resonance from the B light in the white light. The amplified B light goes out from the substrate 22 through the first electrode 24, which is formed so as to function as the half mirror, and reaches the liquid crystal panel 12.

There is light emitted from the organic EL 25 that passes through the second electrode 26 formed so as to function as the half mirror, and that is reflected by the surfaces 28a and 26b in the second resonant layer 32. The thickness t2 is equal to the value that the half of the wavelength of the above light is multiplied by a natural number. In this case, the G light is resonated by the second resonant layer 32 and amplified. The amplified G light goes out from the substrate 22 through the second electrode 26, the organic EL layer 25 and the first electrode 24, and reaches the liquid crystal panel 12.

There is light emitted from the organic EL layer 25 that is reflected by the surfaces 24a and 28a in the third resonant layer 33. The thickness t3 is equal to the value that the half of the wavelength of the above light is multiplied by a natural number. In this case, the R light is resonated by the third resonant layer 33 and amplified. The amplified R light goes out from the substrate 22 and reaches the liquid crystal panel 12. In FIG. 3, a second line 38 indicated by a solid line shows a spectrum of the light that exits from the substrate 22. As shown by the second line 38, the quantities of the light of R (λ1), G (λ2) and B (λ3) are sharply separated. As seen that the peaks of the quantities of the R, G and B lights in the second spectral line 38 are higher than in the first spectral line 37, the resonated R, G and B lights are amplified from the R, G and B lights of the white light.

In the light that has the spectrum shown by the second line 38 and that reaches the liquid crystal panel 12, only the light going to the sub-pixels that is capable of being penetrated comes out to the light output side of the liquid crystal panel 12. At the time, the light passes through the sub pixels of R (red), G (green) or B (blue), which are not shown, in the color filters 19, and the combination of theses colors R, G and B makes a desired color. In this way, an image is to be displayed in a transmissive mode.

In a reflective mode, the backlight 13 is switched off, the drive control device turns off applying the voltage to the backlight 13 between the first and second electrodes 24 and 26, and the organic EL device 23 stops emission. In the state, ambient light comes into the backlight 13 through the liquid crystal panel 12. The ambient light is reflected by the first and second electrodes 24 and 26 and the reflecting mirror 28 and reaches the liquid crystal panel 12. In the ambient light that passes through the first electrode 24 and reaches the organic layer 25, the B, R and G lights are respectively resonated by the first, second and third resonant layers 31 through 33 and travel through the liquid crystal panel 12.

As mentioned above, in the liquid crystal display unit 11, the structure of an optical resonance mirror for resonating the lights with the wavelengths corresponding to R, G and B colors is inserted into an organic EL backlight, or the backlight 13. The spectrum indicated by the second line 38 that shows an emission pattern, in which the quantities of the R, G and B lights are sharply separated, is obtained as shown in FIG. 3. Therefore, the decrease in light transmission at the color filters 19 of the liquid crystal panel 12 is reduced, and a bright display is obtained. Also chromaticity is improved.

According to the preferred embodiment, the following advantageous effects are obtained.

(1) The backlight 13 includes a light source body (the organic EL device 23) and the second resonant layer 32. Also, the organic EL device 23 is formed as the first resonant layer 31, and the backlight 13 includes a plurality of resonant layers. Therefore, the light with a plurality of colors can be resonated, can be amplified and can exit from the backlight 13, resulting in improved brightness.

(2) The light source body (the organic EL device 23) emits the white light. Therefore, since the particular wavelengths of the lights that are amplified by the first, second and third resonant layers 31 through 33 can be randomly selected, an additional layer for converting color need not be provided.

(3) The light source body is the organic EL device 23. Therefore, compared to the case that the light source body is a non-organic EL device, working voltage is lower.

(4) The organic EL layer 25 is combined with the first resonant layer 31 as well as a part of the third resonant layer 33. Therefore, compared to the case that the organic EL layer 25 is separately provided from the first and third resonant layers 31 and 33, the thickness of the light-emitting device, or the backlight 13, is reduced.

(5) The first, second and third resonant layers 31 through 33 are formed so as to resonate the light with a different wavelength respectively. Therefore, the light with a plurality of predetermined colors can be amplified by resonance and can be taken out from the white light.

(6) The first and second resonant layers 31 and 32 are formed so as to be adjacent to each other in the overlapping direction. The first and second resonant layers 31 and 32 need to be formed at different thicknesses, in order to resonate the light with a different wavelength. For example, assuming a configuration that the first and second resonant layers 31 and 32 do not overlap and are arranged in a lateral direction, that is, the each resonator is divided into multiple areas and disposed on the common substrate in a direction perpendicular to the light output direction in which the light is output from the display unit 11, it is difficult to form the first and second resonant layers 31 and 32 at the different thicknesses on the common substrate. However, it is easy to form the first and second resonant layers 31 and 32 at the different thicknesses by forming the first and second resonant layers 31 and 32 so as to overlap. Meanwhile, when the first and second resonant layers 31 and 32 do not overlap and are arranged in the lateral direction, only single wavelength of the light is amplified at each area of the first and second resonant layers 31 and 32. For example, the B light is taken out from only a particular area where the first resonant layer 31 is formed, but not taken out from different area where the second resonant layer 32 is formed. Therefore, the effectively utilized light is limited in the whole area of backlight. In the G light, the effectively utilized light is also limited in a same manner. However, when the first and second resonant layers 31 and 32 are formed so as to overlap, the B light and the G light are taken out from the light emitted from the light source at whole area of the light source. Therefore, the light emitted from the light source is more effectively utilized.

(7) In each of the first, second and third resonant layers 31 through 33, the surfaces of two translucent reflectors, which are formed with a distance from each other in the overlapping direction, face each other. Each of the first, second and third resonant layers 31 through 33 can be formed in a simple structure by determining such that the interval between the two reflector surfaces is equal to the length that the half of the wavelength of the resonated light is multiplied by a natural number.

(8) The first electrode 24 that is the reflector of the first resonant layer 31 is combined with the reflector of the third resonant layer 33. Also, the reflecting mirror 28 that is the reflector of the second resonant layer 32 is combined with the reflector of the third resonant layer 33. Furthermore, the second electrode 26 that is the reflector of the first resonant layer 31 is combined with the reflector of the second resonant layer 32. Therefore, the number of the reflectors does not relatively increase.

(9) The first and second electrodes 24 and 26 are formed so as to function as the half mirrors and are combined with the reflectors of the first resonant layer 31. Therefore, the thickness of the backlight 13 is reduced.

(10) Three resonant layers are formed by forming each reflector so as to satisfy the above-mentioned equations (1) through (3), and three kinds of lights are amplified.

(11) Three kinds of lights can be amplified with only three reflectors. Therefore, the thickness of the light-emitting device can be small, and the decrease in light transmission can be reduced. Also, the third resonant layer 33 can be easily formed by utilizing the first and second resonant layers 31 and 32, which are adjacent to each other in the overlapping direction.

(12) The first, second and third lights, which are resonated by the first, second and third resonant layers 31 through 33 respectively, are the B, G and R lights respectively. Therefore, the light with the three primary colors can be amplified by resonance and can be taken out from the white light. In an RGB color liquid crystal display unit, for example, when the R light resonated by the resonant layer penetrates a color filter of R, the resonant layer is arranged at the second side opposite to the light output side with respect to the color filter 19. Therefore, the brightness and color purity is improved.

(13) The backlight 13 including the organic EL device 23, the first, second and third resonant layers 31 through 33 is fixed to the transmissive liquid crystal panel 12. Therefore, the light with a predetermined color can be amplified by resonance and can be taken out, and a bright display can be obtained.

(14) A total reflection mirror (the reflecting mirror 28) is arranged at the second side opposite to the light output side with respect to the organic EL layer 25. Therefore, the light with a predetermined color from the backlight 13 is amplified by the resonance, and the bright display is obtained. Also, the reflecting mirror 28 reflects the lights that are resonated by the resonant layers 31 through 33. As a result, the amount of the lights to be taken out increases effectively.

(15) The R, G and B lights are amplified by the resonance by the first, second and third resonant layers 31 through 33 and are taken out from the backlight 13. Therefore, the decrease in light transmission at the color filters 19 is reduced, and a bright display is obtained. Also, the chromaticity is improved.

(16) The R, G and B lights resonated by the first, second and third resonant layers 31 through 33 respectively penetrate the color filters 19. For example, the R light resonated by the third resonant layer 33 penetrates an R filter It is also similar as for G and B filters. Therefore, in the light that is emitted from the backlight 13, the light with the same color as the color filter is resonated by the resonant layer and reaches the color filter. Also, the light with the color that is different from the color filter is weakened and reaches the color filter. As a result, the thickness of the color filter can be small, and the decrease in light transmission at the color filter is reduced further. Also, the color purity of the light that penetrates the color filter is enhanced.

(17) The color filters 19 include R, G and B colors. The light with the three primary colors, which is amplified from the white light by resonance, penetrates the color filters 19. Therefore, the brightness and the color purity is improved.

The present invention is not limited to the above-mentioned preferred embodiment, and, for example, the following alternative embodiments may be practiced. The same reference numerals denote the substantially identical elements as those in the above-mentioned preferred embodiment.

i) The organic EL device 23 is not limited to be layered on the substrate 22, and the buffer layer 27 is not limited to be layered on the organic EL device 23 in a first alternative preferred embodiment. The buffer layer 27 may be layered on the substrate 22, and the organic EL device 23 may be layered on the buffer layer 27. For example, as shown in FIG. 4, a half mirror 51 made of metal is layered on the substrate 22, and the buffer layer 27 is layered on the half mirror 51. The first electrode 24, the organic EL layer 25 and the second electrode 26 are layered on the buffer layer 27 in order of mention. The first electrode 24 is layered so as to function as a half mirror, and the second electrode 26 is also layered so as to function as a mirror. The passivation film 29 is layered so as to cover the whole area. In this case, the reflecting surfaces of a second reflecting layer 52 consist of a surface 51 a of the half mirror 51 at the side of the buffer layer 27 and a surface 24b of the first electrode 24 at a side opposite to the organic EL layer 25. The reflecting surfaces of a third resonant layer 53 consist of the surface 51 a and a surface 26a of the second electrode 26 at the side of the organic EL layer 25. There are the buffer layer 27, the first electrode 24 and the organic EL layer 25 between the surfaces 26a and 51 a. In the structure, the half mirror 51 and the buffer layer 27 are formed before forming the organic EL device 23. Accordingly, the half mirror 51 and the buffer layer 27 can be formed without carefully controlling the layers' temperature that could affect a decay of the organic EL layer 25. Therefore, with respect to manufacturing a product, the backlight 13 of the first alternative preferred embodiment is formed more easily than the backlight 13 of the above-mentioned preferred embodiment.

ii) As the thickness of the backlight 13 decreases, the decrease in light transmission reduces.

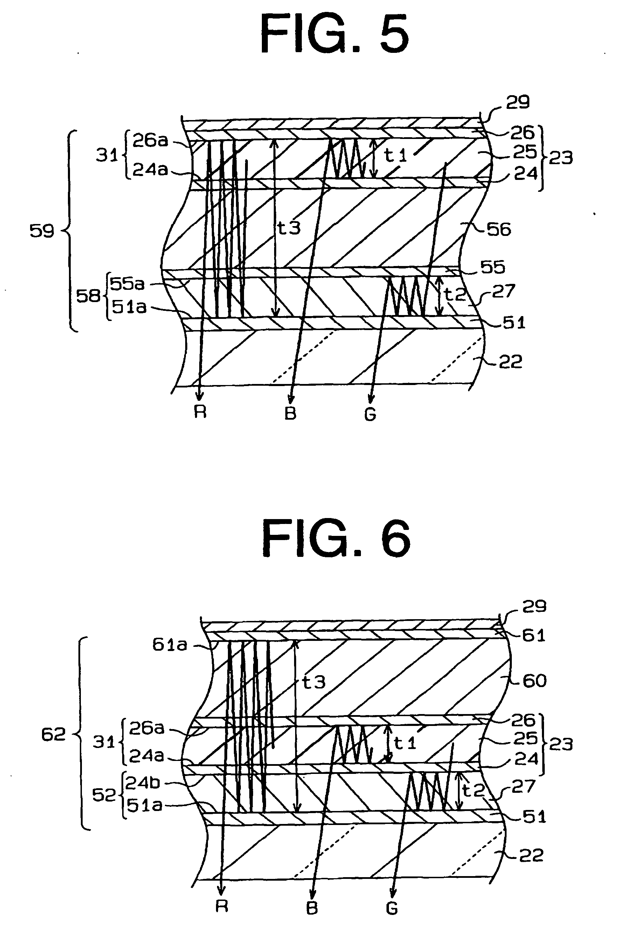

iii) The first resonant layer 31 is not limited to be adjacent to the second resonant layer 32 in the overlapping direction. For example, another layer may be interposed between the first and second resonant layers 31 and 32, and the first and second resonant layers 31 and 32 may be formed at a distance from each other in the overlapping direction. For example, as shown in FIG. 5, the buffer layer 27 is layered on the half mirror 51, which is formed on the substrate 22, and a half mirror 55 is layered on the buffer layer 27. A buffer layer 56 is layered on the half mirror 55, and the organic EL device 23 is layered on the buffer layer 56. And then, the reflecting surfaces of a second resonant layer 58 comprise a surface 51 a of the half mirror 51 and a surface 55a of the half mirror 55 at the side of the buffer layer 27. The reflecting surfaces of a third resonant layer 59 comprise the surface 51 a and the surface 26a of the second electrode 26 at the side of the organic EL layer 25. There are the buffer layer 27, the half mirror 55, the buffer layer 56, the first electrode 24 and the organic EL layer 25 between the surfaces 26a and 51 a. The thickness of the third buffer layer 56 is determined such that the interval between the surfaces 26a and 51 a is equal to a length that the half of the wavelength λ3 is multiplied by a natural number. In this case, after the thickness t1 and t2 are determined, the thickness t3 can be determined by determining the thickness of the third buffer layer 56. Therefore, degree of freedom in designing is improved.

iv) In an alternative example one of the reflecting surfaces of the first resonant layer or one of the reflecting surfaces of the second resonant layer may be served as only one of the reflecting surfaces of the third resonant layer. For example, as shown in FIG. 6, the second resonant layer 52 and the first resonant layer 31 are arranged on the substrate 22. A transparent buffer layer 60 and a reflecting mirror 61 are layered on the second electrode 26 in order of mention. The passivation film 29 is layered on the reflecting mirror 61. The reflecting surfaces of a third resonant layer 62 comprise the surface 51 a of the half mirror 51 and a surface 61a of the reflecting mirror 61. There are the buffer layer 27, the first electrode 24, the organic EL layer 25, the second electrode 26 and the buffer layer 60 between the surfaces 51a and 61a. The thickness of the buffer layer 60 is determined such that the interval between the surfaces 51a and 61a is equal to a length that the half of the wavelength λ3 is multiplied by a natural number. In this case also, after the thickness t1 and t2 are determined, the thickness t3 can be determined by determining the thickness of the buffer layer 60. Therefore, degree of freedom in designing is improved.

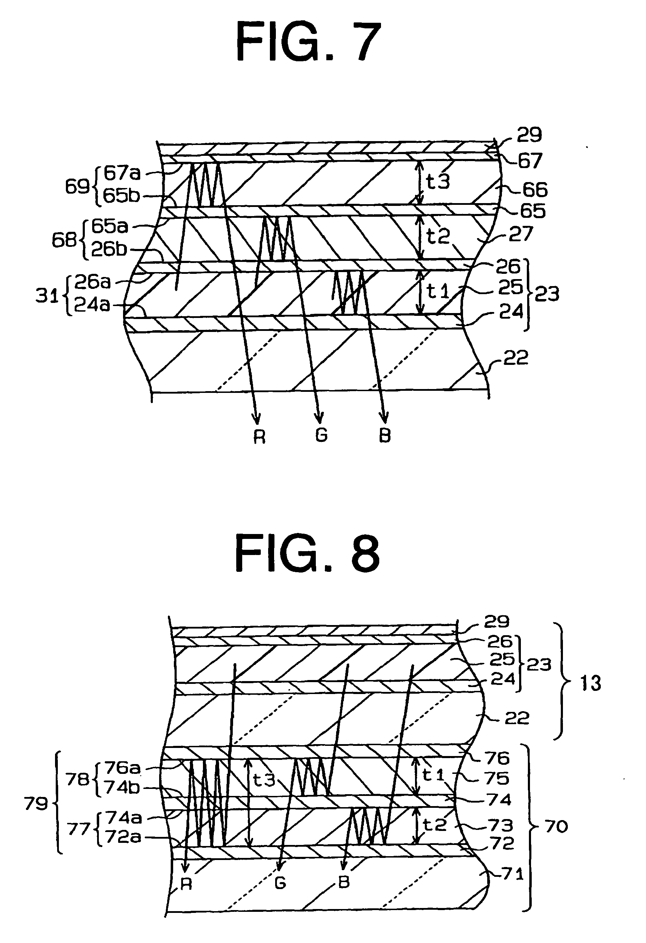

v) Each resonant layer may be formed so as not to share the reflecting surfaces of the other resonant layers. For example, as shown in FIG. 7, in a state that the organic EL device 23 and the buffer layer 27 are formed on the substrate 22 in order of mention, the half mirror 65 is layered on the buffer layer 27. And then, a buffer layer 66 is layered on the half mirror 65, and a reflecting mirror 67 is layered on the buffer layer 66. The passivation layer 29 is layered on the reflecting mirror 67. A couple of reflecting surfaces of a second resonant layer 68 comprises the surface 26b of the second electrode 26 and a surface 65a of the half mirror 65. A couple of reflecting surfaces of a third resonant layer 69 comprises a surface 65b of the half mirror 65 and a surface 67a of the reflecting mirror 67. According to this in case of the thickness of any resonant layers being different from a desired value, the difference does not affect the thickness of the others, because each resonator is provided independently from each other. Therefore, the difference does not affect the resonance of the other resonant layers.

vi) The distance between the surface 24a of the first electrode 24 and the surface 26a of the second electrode 26 that face each other may be smaller than the half of the wavelength of the resonated light It is assumed that a couple of surfaces of the first resonant layer comprises the surface 24a and the surface 65a of the half mirror 65 at the side of organic EL layer 25 in FIG. 7. In this case, thickness required for resonating by the first resonant layer can be ensured by determining the thickness of the buffer layer 27. Therefore, the thickness of the organic EL layer 25 can be smaller than the half of the wavelength of the light resonated by the first resonant layer.

vii) The organic EL layer 25 may not be combined with the resonant layer in an alternative preferred embodiment. As shown in FIG. 8, a backlight, in which the organic EL device 23 is formed on the substrate 22 and is covered with the passivation film 29, is provided. An optical resonator 70 is arranged between the backlight and the liquid crystal panel. The first electrode 24 is made of ITO so as to be a transparent electrode, and the second electrode 26 is made of aluminum so as to be a reflecting electrode. In the optical resonator 70, a half mirror 72, a transparent buffer layer 73, a half mirror 74, a transparent buffer layer 75 and half mirror 76 are layered on a glass substrate 71 in order of mention. A couple of surfaces of a first resonant layer 77 comprises a surface 72a of the half mirror 72 and a surface 74a of the half mirror 74 at the side of the buffer layer 73. A couple of surfaces of a second resonant layer 78 comprises a surface 74b of the half mirror 74 and a surface 76a of the half mirror 76 at the side of the buffer layer 75. A couple of surfaces of a third resonant layer 79 comprises the surfaces 72a and 76a. In this case, the optical resonator 70 is formed separately from the backlight 13 and is fixed to the backlight 13. Therefore, a resonant layer can be fixed to an existing backlight.
The optical resonator 70 includes the first resonant layer 77, in which the surface 72a of the half mirror 72 arranged at the light output side faces the surface 74a of the half mirror 74. Also, the optical resonator 70 includes the second resonant layer 78, in which the surface 74b of the second half mirror 74 faces the surface 76a of the half mirror 76, and the third resonant layer 79, in which the surface 72a of the half mirror 72 faces the surface 76a of the third half mirror 76. Therefore, the light with a predetermined wavelength can be resonated by determining the distance between both reflecting surfaces. The light with a predetermined color can be amplified from the light emitted at the backlight 13, and brightness is improved.
The optical resonator 70 is formed separately from the backlight 13 and then is fixed to the backlight 13. Therefore, a resonant layer can be fixed to an existing backlight, and even the light emitted from an existing light source body can be amplified. Also, when the organic EL device 23 serves as the backlight 13, for example, the optical resonator 70 can be formed without carefully controlling the layers' temperature that could affect a decay of the organic EL layer 25. Therefore, with respect to manufacturing a product, the backlight 13, to which the resonant layer is fixed, is easily formed.

In each of the first and second resonant layers 77 and 78, the reflectors formed on both surfaces of the transparent layer (the buffer layer) are half mirrors. Therefore, both reflectors can be formed in a same procedure.

viii) In an alternative preferred embodiment, when the resonant layers 77 through 79 are formed as mentioned above, the half mirror 76, the buffer layer 75, the half mirror 74, the buffer layer 73 and the half mirror 72 may be layered on the substrate 22 of the backlight 13 at the side opposite to the organic EL device 23 in order of mention so as to form the resonant layers 77 through 79.

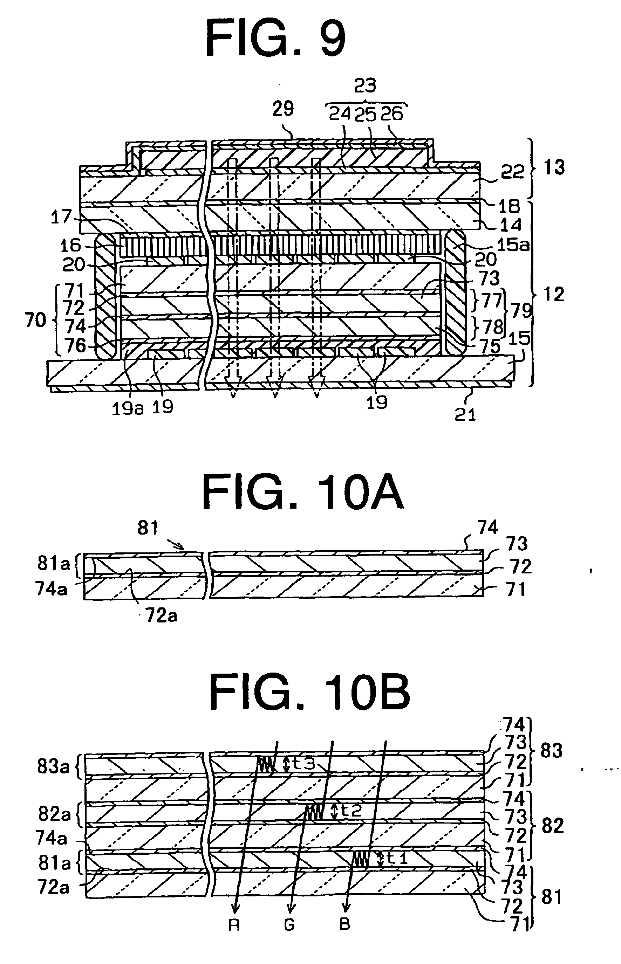

ix) The above-mentioned optical resonator 70 may be arranged at any position between the color filters 19 and the organic EL layer 25 in an alternative preferred embodiment. For example, the optical resonator 70 may be arranged in the liquid crystal panel 12 as shown in FIG. 9.

x) All reflectors of the resonant layers may be translucent and may be arranged adjacent to the side of the liquid crystal display panel 12 rather than the side of an emission portion of the backlight 13, or the organic EL device 23, in a tenth alternative preferred embodiment. In this case, not only the light from the backlight 13 but also ambient light from the outside of the display unit 11 can be utilized for displaying.

xi) The above-mentioned optical resonator 70 may be arranged at the light output side with respect to the color filters 19 in an alternative preferred embodiment. In this case, the brightness is improved.

xii) An optical resonator is not limited to have a structure that includes three resonant layers in an alternative preferred embodiment. For example, two separate optical resonators one of which has single resonant layer and another of which has double resonant layers are provided, and one of the optical resonators may be fixed to the backlight 13, and the other optical resonator may be arranged in the liquid crystal display panel 12. Alternatively, both optical resonators may be overlapped and may be fixed to the backlight 13.

xiii) Although the above-mentioned optical resonator 70 includes the three resonant layers 77 through 79 in the above-mentioned alternative preferred embodiment, one optical resonator may include one resonant layer. For example, as shown in FIG. 10A, in an optical resonator 81 for resonating the B light, the substrate 71, the half mirror 72, the buffer layer 73 and the half mirror 74 are formed in order of mention. The optical resonator 81 includes a resonant layer 81 a for resonating the B light as a first resonant layer in which surfaces 72a and 74a face each other. Similarly, as shown in FIG. 10B, an optical resonator 82 includes a resonant layer 82a for resonating the G light as a second resonant layer, and an optical resonator 83 includes a resonant layer 83a for resonating the R light as a third resonant layer. The optical resonators 81 through 83 for the R, G and B lights are manufactured individually, may be stacked up and may be fixed to the backlight 13.

xiv) The above-mentioned optical resonator 70 may be formed so as to have flexibility in an alternative preferred embodiment. For example, the optical resonator 70 may form a film. In this case, the substrate 71 of the optical resonator 70 is made of transparent resin so as to have flexibility. The optical resonator 70 can be applied to the light source body having a curved surface.

xv) In an alternative preferred embodiment, when the optical resonator 70 is formed so as to have flexibility as mentioned above, the thickness of the optical resonator 70 may be larger than that of a film. For example, the optical resonator 70 may form a sheet.

xvi) In an alternative preferred embodiment, the first and second electrodes 24 and 26 of the organic EL device 23 may be transparent electrodes, and the optical resonator 70 may be arranged adjacent to a side opposite to the light output side of the backlight 13. And then, the reflector of the optical resonator 70 that is located furthest from the backlight 13 is a total reflection mirror, and the other reflectors are half mirrors. Also, in this case, a gap or a transparent solid body layer may be provided between the backlight 13 and the optical resonator 70. Accordingly, the optical resonator 70 functions as a reflector for amplifying the light with a predetermined wavelength. Therefore, for example, the amount of the light with the predetermined wavelength can be increased.

xvii) In an alternative preferred embodiment, the backlight 13 may be a top emission type in which the light emitted from the organic EL device 23 is taken out from a side opposite to the side of the substrate 22.

xviii) Means that seal the organic EL device 23 are not limited to the passivation film 29 in an alternative preferred embodiment. For example, a cover that blocks water and oxygen from permeating and that is made of transparent material such as glass may be arranged instead of the passivation film 29. A sealing member (e.g. polysilazane), which is not shown, may be arranged between the cover and the substrate 22, so as to prevent the organic EL layer 25 from being exposed to water and oxygen.

xix) In the structure of the bottom emission type, instead of the passivation film 29, the organic EL device 23 may be sealed by a sealing can (a sealing cover) made of metal in alternative preferred embodiment.

xx) The buffer layers 27, 56, 60, 66, 73 and 75 may be made of transparent material, such as silicon nitride in an alternative preferred embodiment. Also, the buffer layers 27, 56, 60, 66, 73 and 75 may be constituted of transparent organic layers such as material of an overcoat for a color filter, or other non-organic layers.

xxi) The half mirrors in the above-mentioned preferred embodiment are not limited to be made of aluminum in an alternative preferred embodiment. For example, the half mirror may be made of sliver. Or, the half mirrors may be made of alloy that is constituted of magnesium and silver.

xxii) In an alternative preferred embodiment, the first electrode 24 may be made of silver, chromium, molybdenum, or an alloy that is composed of silver, chromium and molybdenum. Or, the first electrode 24 may be made of an aluminum-palladium-copper alloy.

xxiv) The first electrode 24 may be a cathode, and the second electrode 26 may be an anode in an alternative preferred embodiment.

xxv) The liquid crystal panel 12 may be a transmissive type or a semi-transmissive type. The liquid crystal panel 12 is not limited to employ the passive matrix mode and, for example, may employ an active matrix mode in an alternative preferred embodiment.

xxvi) The backlight 13 is not limited to have a structure for emitting light at its whole area in an alternative preferred embodiment. For example, the backlight 13 may be divided into a plurality of areas that are capable of lighting individually, and the areas corresponding to pixels of the liquid crystal panel 12 may selectively light. In this case, compared to the backlight 13 that has the structure for emitting light at its whole area, the electrical power consumption can be reduced.

xxvii) In an alternative preferred embodiment, the light-emitting device is not limited to the backlight 13 of the liquid crystal display unit 11, and, for example, the light-emitting device may be formed as a room lamp of a vehicle or as a lighting unit to hang in an interior. In this case, compared to a lighting unit including a conventional light-emitting device as a light source, the color of the light is vivid.

xxviii) In alternative preferred embodiment, the light source body is not limited to the organic EL device, and, for example, the light source body may be a non-organic EL device. Also, the light source body may be a device other than the EL device. The optical resonator 70 can amplify the light with a predetermined wavelength from any light source body.

xxix) In an alternative preferred embodiment, the resonated lights are not limited to include R, G and B colors and may include other colors.

xxx) In an alternative preferred embodiment, the number of the colors of the resonated lights is not limited to three. For example, the number may be two.

xxxi) In an alternative preferred embodiment, the optical resonator 70 may include four resonant layers or more. For example, the resonant layers may be provided so as to resonate the lights with a combination of four colors or more other than red, blue and green.

xxxii) The light source body is not limited to emit the white light in an alternative preferred embodiment.

The present embodiments are to be considered as illustrative and not restrictive, and the invention is not to be limited to the details given herein but may be modified within the scope of the appended claims.
A light-emitting device includes a light source body and a plurality of resonant layers. The light source body generates light. Each of the plurality of resonant layers resonates the light with a predetermined wavelength. Each of the wavelengths of the light resonated by the resonant layers is different from at least one of the other wavelengths of the light resonated by the resonant layers.

**Claims**

1. A light emitting device (13) having a light source body (23) generating light and a plurality of resonant cavities (31, 32), wherein the plurality of the resonant cavities overlap in the direction in which the light is emitted from the device,

each of the plurality of resonant cavities including a buffer layer (25, 27), a reflecting surface (24a, 26b) of a first reflector in contact with the buffer layer (25, 27) and a reflecting surface (26a, 28a) of a second reflector in contact with the buffer layer, each of the plurality of resonant cavities resonating the light with a predetermined wavelength (B, G), the resonated light being emitted from the device,

**characterized in that**

each of the wavelengths of the light resonated by the resonant cavities is different from at least one of the other wavelengths of the light resonated by the resonant cavities,

and the thicknesses of the resonant cavities are chosen such that light resonated between the reflecting surface (24a) of one of the first and second reflectors of one of the plurality of resonant cavities and the reflecting surface (28a) of one of the first and second reflectors of another of the plurality of resonant cavities has a different predetermined wavelength (R) from the light resonated by one or more of the resonant cavities, which light is emitted from the device.

2. The light-emitting device according to claim 1, wherein the tight source body (23) emits white light.

3. The light-emitting device according to claim 1 or 2, wherein the light source body is an organic electroluminescent device.

4. The light-emitting device according to claim 3, wherein the organic electroluminescent device includes an organic electroluminescent layer (25) that is formed in one of the resonant cavities and electrodes (24, 26) that form at least one of the resonant cavities, the organic electroluminescent layer being the buffer layer thereof, the electrodes being the first and second reflectors thereof.

5. The light-emitting device according to any one of claims 1 to 4, wherein the plurality of resonant cavities is formed adjacent to each other in a direction in which the resonant cavities overlap.

6. The light-emitting device according to any one of claims 1 to 5, wherein at least one of the plurality of resonant cavities (77, 78, 79) is flexible.

7. The light-emitting device according to claim 3, wherein the light source body (23) is an organic electroluminescent device including an electrode, and at least one of the first and second reflectors (24, 26, 28) of at least one of the plurality of the resonant cavities serving as the electrode.

8. The light-emitting device according to any one of claims 1 to 5, wherein each of the plurality of resonant cavities is formed at a distance from each other with a layer interposed therebetween in a direction in which the resonant cavities overlap.

9. The light-emitting device according to any one of claims 1 to 8, wherein at least one of the first and second reflectors of at least one of the plurality of the resonant cavities serves as the reflector for more than one of the plurality of resonant cavities.

10. The light-emitting device according to any one of claims 1 to 9, wherein one of the first and second reflectors (26, 28) of one of the plurality of the resonant cavities totally reflects the light.

11. A display unit (11) comprising a liquid crystal display (12) and a light-emitting device according to claim 1 being arranged at the back side of the liquid crystal display so as to serve as a backlight (13).

12. The display unit according to claim 11, wherein the liquid crystal display (12) includes a color filter (19), the light emitted from the light-emitting device includes a plurality of colors, at least one of the lights resonated by the light-emitting device penetrates the color filter.

13. The display unit according to claim 12, wherein the color filter (19) includes red, green and blue colors, the resonated light being red light, blue light and green light.

14. A lighting unit comprising a light-emitting device (13) as a light source according to claim 1.

15. The light-emitting device according to claim 1, wherein the plurality of the resonant cavities includes two resonant cavities, the resonated light having the wavelengths being respectively blue light, green light and red light.

**Patentansprüche**

1. Lichtemittierende Vorrichtung (13) mit einem Licht erzeugenden Lichtquellenkörper (23) und einer Vielzahl von Resonanzräumen (31, 32), wobei die Vielzahl der Resonanzräume in der Richtung überlappen, in welcher das Licht von der Vorrichtung emittiert wird,

wobei jeder der Vielzahl von Resonanzräume eine Pufferschicht (25, 27), eine reflektierende Oberfläche (24a, 26b) eines ersten Reflektors in Kontakt mit der Pufferschicht (25, 27) und eine reflektierende Oberfläche (26a, 28a) eines zweiten Reflektors in Kontakt mit der Pufferschicht umfasst, wobei jeder der Vielzahl von Resonanzräume das Licht mit einer vorbestimmten Wellenlänge (B, G) zum Schwingen bringt, und wobei das zum Schwingen gebrachte Licht von der Vorrichtung emittiert wird, **dadurch gekennzeichnet, dass** jede der Wellenlängen des durch die Resonanzräume zum Schwingen gebrachten Lichts von zumindest einer der anderen Wellenlängen des durch die Resonanzräume zum Schwingen gebrachten Lichts verschieden ist, und die Dicken der Resonanzräume derart gewählt sind, dass zwischen der reflektierenden Oberfläche (24a) von einem der ersten und zweiten Reflektoren eines der Vielzahl von Resonanzräumen und der reflektierenden Oberfläche (28a) von einem der ersten und zweiten Reflektoren eines anderen der Vielzahl von Resonanzräumen zum Schwingen gebrachtes Licht eine vorbestimmte Wellenlänge (R) hat, welche von dem durch einen oder mehr der Resonanzräume zum Schwingen gebrachten Licht verschieden ist, welches Licht von der Vorrichtung emittiert wird.

2. Lichtemittierende Vorrichtung nach Anspruch 1, wobei der Lichtquellenkörper (23) weißes Licht emittiert.

3. Lichtemittierende Vorrichtung nach Anspruch 1 oder 2, wobei der Lichtquellenkörper eine organische Elektrolumineszenzvorrichtung ist.

4. Lichtemittierende Vorrichtung nach Anspruch 3, wobei die organische Elektrolumineszenzvorrichtung eine in einer der Resonanzräume gebildete organische Elektrolumineszenzschicht (25) und Elektroden (24, 26) umfasst, welche zumindest einen der Resonanzräume bilden, wobei die organische Elektrolumineszenzschicht seine Pufferschicht ist, und die Elektroden seine ersten und zweiten Reflektoren sind.

5. Lichtemittierende Vorrichtung nach einem der Ansprüche 1 bis 4, wobei die Vielzahl von Resonanzräumen benachbart zueinander in einer Richtung gebildet sind, in welcher die Resonanzräume überlappen.

6. Lichtemittierende Vorrichtung nach einem der Ansprüche 1 bis 5, wobei zumindest einer der Vielzahl von Resonanzräumen (77, 78, 79) flexibel ist.

7. Lichtemittierende Vorrichtung nach Anspruch 3, wobei der Lichtquellenkörper (23) eine eine Elektrode umfassende organische Elektrolumineszenzvorrichtung ist, und zumindest einer der ersten und zweiten Reflektoren (24, 26, 28) von zumindest einem der Vielzahl der Resonanzräume als die Elektrode dient.

8. Lichtemittierende Vorrichtung nach einem der Ansprüche 1 bis 5, wobei jeder der Vielzahl von Resonanzräume mit einem Abstand voneinander mit einer dazwischen eingelegten Schicht in einer Richtung gebildet ist, in welcher die Resonanzräume überlappen.

9. Lichtemittierende Vorrichtung nach einem der Ansprüche 1 bis 8, wobei zumindest einer der ersten und zweiten Reflektoren von zumindest einem der Vielzahl der Resonanzräume als der Reflektor für mehr als einen der Vielzahl von Resonanzräume dient.

10. Lichtemittierende Vorrichtung nach einem der Ansprüche 1 bis 9, wobei einer der ersten und zweiten Reflektoren (26, 28) von einem der Vielzahl der Resonanzräume das Licht totalreflektiert.

11. Anzeigeeinheit (11) mit einer Flüssigkristallanzeige (12) und einer lichtemittierenden Vorrichtung nach Anspruch 1, welche an der Rückseite der Flüssigkristallanzeige angeordnet ist, damit sie als eine Hintergrundbeleuchtung (13) dient.

12. Anzeigeeinheit nach Anspruch 11, wobei die Flüssigkristallanzeige (12) ein Farbfilter (19) umfasst, wobei das von der lichtemittierenden Vorrichtung emittierte Licht eine Vielzahl von Farben umfasst, und wobei zumindest eins der durch die lichtemittierende Vorrichtung zum Schwingen gebrachten Lichter das Farbfilter durchdringt.

13. Anzeigeeinheit nach Anspruch 12, wobei das Farbfilter (19) die Farben Rot, Grün, und Blau umfasst, wobei das zum Schwingen gebrachte Licht rotes Licht, blaues Licht und grünes Licht ist.

14. Beleuchtungseinheit mit einer lichtemittierenden Vorrichtung (13) als eine Lichtquelle nach Anspruch 1.

15. Lichtemittierende Vorrichtung nach Anspruch 1, wobei die Vielzahl der Resonanzräume zwei Resonanzräume umfasst, und wobei das zum Schwingen gebrachte Licht jeweils die Wellenlängen von blauem Licht, grünem Licht und rotem Licht aufweist.

**Revendications**

1. Dispositif émetteur de lumière (13) ayant un corps de source lumineuse (23) générant de la lumière, et une pluralité de cavités de résonance (31, 32), dans lequel la pluralité de cavités de résonance se recouvrent dans la direction dans laquelle la lumière est émise à partir du dispositif, chacune de la pluralité de cavités de résonance incluant une couche tampon (25, 27), une surface réfléchissante (24a, 26b) d'un premier réflecteur en contact avec la couche tampon (25, 27), et une surface réfléchissante (26a, 28a) d'un deuxième réflecteur en contact avec la couche tampon, chacune de la pluralité de cavités de résonance faisant résonner la lumière avec une longueur d'onde (B, G) prédéterminée, la lumière résonnée étant émise à partir du dispositif,

**caractérisé en ce que** chacune des longueurs d'onde de la lumière résonnée par les cavités de résonance est différente d'au moins l'une des autres longueurs d'ondes de la lumière résonnée par les cavités de résonance, et **en ce que** les épaisseurs des cavités de résonance sont choisies de telle sorte que la lumière résonnée entre la surface réfléchissante (24a) de l'un des premier et deuxième réflecteurs de l'une de la pluralité des cavités de résonance et la surface réfléchissante (28a) de l'un des premier et deuxième réflecteurs d'une autre de la pluralité des cavités de résonance a une longueur d'onde prédéterminée (R) différente de la lumière résonnée par au moins une ou plusieurs des cavités de résonance, laquelle lumière est émise à partir du dispositif.

2. Dispositif émetteur de lumière selon la revendication 1, dans lequel le corps de source lumineuse (23) émet une lumière blanche.

3. Dispositif émetteur de lumière selon la revendication 1 ou 2, dans lequel le corps de source lumineuse est un dispositif électroluminescent organique.

4. Dispositif émetteur de lumière selon la revendication 3, dans lequel le dispositif électroluminescent organique inclut une couche électroluminescente organique (25) qui est formée dans l'une des cavités de résonance, et des électrodes (24, 26) qui forment au moins l'une des cavités de résonance, la couche électroluminescente organique étant la couche tampon de celui-ci, les électrodes étant les premier et deuxième réflecteurs de celui-ci.

5. Dispositif émetteur de lumière selon l'une quelconque des revendications 1 à 4, dans lequel la pluralité de cavités de résonance sont formées de façon adjacente entre elles, dans une direction dans laquelle les cavités de résonance se recouvrent.

6. Dispositif émetteur de lumière selon l'une quelconque des revendications 1 à 5, dans lequel au moins l'une de la pluralité de cavités de résonance (77, 78, 79) est flexible.

7. Dispositif émetteur de lumière selon la revendication 3, dans lequel le corps de source lumineuse (23) est un dispositif électroluminescent organique incluant une électrode, et au moins l'un des premier et deuxième réflecteurs (24, 26, 28) d'au moins l'une de la pluralité de cavités de résonance servant d'électrode.

8. Dispositif émetteur de lumière selon l'une quelconque des revendications 1 à 5, dans lequel chacune de la pluralité de cavités de résonance est formée à distance des autres cavités de résonance, une couche étant intercalées entre elles, dans une direction dans laquelle les cavités de résonance se recouvrent.

9. Dispositif émetteur de lumière selon l'une quelconque des revendications 1 à 8, dans lequel au moins l'un des premier et deuxième réflecteurs d'au moins l'une de la pluralité des cavités de résonance sert de réflecteur pour plus d'une cavité de la pluralité de cavités de résonance.

10. Dispositif émetteur de lumière selon l'une quelconque des revendications 1 à 9, dans lequel l'un des premier et deuxième réflecteurs (26, 28) de l'une de la pluralité des cavités de résonance réfléchit totalement la lumière.

11. Unité d'affichage (11), comprenant un écran à cristaux liquides (12) et un dispositif émetteur de lumière selon la revendication 1, agencé sur le côté arrière de l'écran à cristaux liquides, de manière à servir de rétroéclairage (13).

12. Unité d'affichage selon la revendication 11, dans lequel l'écran à cristaux liquides (12) inclut un filtre coloré (19), la lumière émise à partir du dispositif émetteur de lumière inclut une pluralité de couleurs, au moins l'une des lumières résonnées par le dispositif émetteur de lumière pénètre dans le filtre coloré.

13. Unité d'affichage selon la revendication 12, dans lequel le filtre coloré (19) inclut, comme couleurs, le rouge, le vert et le bleu, la lumière résonnée étant une lumière rouge, une lumière bleue et une lumière verte.

14. Unité d'éclairage comprenant un dispositif émetteur de lumière (13) sous la forme d'une source lumineuse, selon la revendication 1.

15. Dispositif émetteur de lumière selon la revendication 1, dans lequel la pluralité de cavités de résonance inclut deux cavités de résonance, la lumière résonnée ayant les longueurs d'onde étant respectivement une lumière bleue, une lumière verte et une lumière rouge.

EP 1 403 939 B1

# FIG. 1

# FIG. 2

# FIG. 3

# FIG. 4

# FIG. 5

# FIG. 6

# FIG. 7

# FIG. 8

# FIG. 9

# FIG. 10A

# FIG. 10B